(19) Europäisches Patentamt
European Patent Office
Office européen des brevets

(11) Publication number : **0 467 655 B1**

# (12) EUROPEAN PATENT SPECIFICATION

(45) Date of publication of patent specification :
**14.06.95 Bulletin 95/24**

(51) Int. Cl.$^6$ : **H03F 3/45,** H03F 1/02

(21) Application number : **91306470.5**

(22) Date of filing : **16.07.91**

## (54) Differential amplifying circuit.

(30) Priority : **17.07.90 JP 188552/90**

(43) Date of publication of application :
**22.01.92 Bulletin 92/04**

(45) Publication of the grant of the patent :
**14.06.95 Bulletin 95/24**

(84) Designated Contracting States :
**DE FR GB**

(56) References cited :
**FR-A- 2 640 094**
**US-A- 4 797 629**
**US-A- 4 928 073**
**PATENT ABSTRACTS OF JAPAN vol. 9, no. 131 (E-319)(1854) June 6, 1985**

(73) Proprietor : **NEC CORPORATION**
**7-1, Shiba 5-chome**
**Minato-ku**
**Tokyo (JP)**

(72) Inventor : **Sugawara, Mitsutoshi, c/o NEC Corporation**
**7-1, Shiba 5-chome**
**Minato-ku, Tokyo (JP)**

(74) Representative : **Garratt, Peter Douglas et al**
**Mathys & Squire**
**100 Grays Inn Road**
**London WC1X 8AL (GB)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Jouve, 18, rue Saint-Denis, 75001 PARIS

## Description

This invention relates to a differential amplifying circuit, and more particularly to, a differential amplifying circuit provided with at least one emitter follower circuit connected to an input thereof.

A conventional differential amplifying circuit includes first and second transistors, first and second load resistances and a first constant current source, and it is usually provided with an emitter follower circuit connected to an input of the circuit for increasing an input impedance thereof.

The first and second transistors are connected at emitters with the first constant current source commonly, and at bases with emitters of first and second emitter follower transistors, respectively. The first and second load resistances are connected at first terminals to collectors of the first and second transistors, respectively, and at second terminals to a positive terminal of a direct current power supply commonly. The first and second emitter follower transistors are connected at collectors to the positive terminal of the direct current power supply commonly, at bases to a signal source in which positive and negative components are supplied to the bases of the first and second emitter follower transistors respectively, and at emitters to second and third constant current sources, respectively. The first to third constant current sources are connected to a negative terminal of the direct current power supply commonly.

In operation, an input signal is supplied differentially to the bases of the emitter follower transistors with bias voltage, and is amplified by the first and second transistors to be supplied to first and second output terminals provided at the collectors of the first and second transistors, respectively. In general, the outputs of the terminals may be amplified differentially in a differential amplifying circuit of the next stage.

According to the conventional differential amplifying circuit, however, there is a disadvantage in that the second and third constant current sources for driving the emitter follower transistors consume a considerable value of power which is a multiple of currents flowing through the constant current sources and a voltage of the direct current power supply.

In case of the circuit used in a high frequency (1 GHz, for example) range, the constant current sources are required to make currents sufficient for discharging a suspended capacity of the differential amplifying circuit and an input capacity of a differential amplifying circuit of the next stage, so that the currents may become 10 mA in some cases. In case of the circuit used as a low noise amplifier, the constant current sources are required to make currents sufficient for reducing shot noises to a predetermined level (it is known that the noise power level is inversely proportional to the current).

Further, a problem may occur, if the input bias current thereof is large. If the input signal source is an output of a magnetic head of a magnetic recording device such as a floppy disk driver, miss writing operation may occur in reproducing mode, so that recorded signals may be unable to reproduce, because of an offset of the input bias current. Therefore, the input bias current should be a low level. On the other hand, the constant current of the constant current source which supplies a bias current of the differential amplifying circuit is required to be a sufficiently large current in considering the gain, and noise and frequency characteristics.

Such a disadvantage may cause a short-life of batteries in a set driven by batteries or decrease of integration of LSIs to reduce a power consumption within an allowable loss thereof.

Accordingly, it is an object of the invention to provide a differential amplifying circuit in which a consumption power is reduced.

According to a feature of the invention, a differential amplifying circuit comprises:

first and second transistors for differentially amplifying an input signal;

first and second load elements;

a constant current source; and

an emitter follower transistor; wherein:

the first and second transistors are connected at emitters to the constant current source commonly, and at collectors to first terminals of the first and second load elements, respectively;

the first transistor is connected at a base to an emitter of said emitter follower transistor;

the first and second load elements are connected at second terminals to an emitter of the emitter follower transistor commonly; and

the emitter follower transistor is connected with a signal source for supplying the input signal thereto with a bias voltage.

The invention will be explained in more detail and by way of example, in conjunction with appended drawings wherein:

Fig. 1 is a circuit diagram of a conventional differential amplifying circuit;

Fig. 2 is a circuit diagram of a differential amplifying circuit in a first preferred embodiment according to the invention;

Fig. 3 is a circuit diagram of a differential amplifying circuit in a second preferred embodiment according to the invention;

Fig. 4 is a circuit diagram of a differential amplifying circuit in a third preferred embodiment according to the invention;

Fig. 5 is a circuit diagram of a differential amplifying circuit in a fourth preferred embodiment according to the invention;

Fig. 6 is a circuit diagram of a differential amplifying circuit in a fifth preferred embodiment according to the invention; and

Fig. 7 is a circuit diagram of a differential amplifying circuit in a sixth preferred embodiment according to the invention.

Before describing a differential amplifying circuit in preferred embodiments according to the invention, the conventional differential amplifying circuit described before will be explained in conjunction with Fig.1.

The conventional differential amplifying circuit includes first and second transistors $Q_1$ and $Q_2$, first and second load resistances $R_1$ and $R_2$, and a first constant current source $I_0$.

The first and second transistors $Q_1$ and $Q_2$ are connected at emitters with the first constant current source $I_0$ commonly, and at bases with emitters of first and second emitter follower transistors $Q_3$ and $Q_4$ , respectively. The first and second load resistances $R_1$ and $R_2$ are connected at first terminals to collectors of the first and second transistors $Q_1$ and $Q_2$ , and at second terminals to a positive terminal of a direct current power supply $V_{CC}$ commonly. The first and second emitter follower transistors $Q_3$ and $Q_4$ are connected at collectors to the positive terminal of the direct current power supply $V_{CC}$ commonly, at bases with a signal source $V_S$ in which positive and negative components are supplied to the bases of the first and second emitter follower transistors $Q_3$ and $Q_4$ respectively, and at emitters to second and third constant current sources $I_1$ and $I_2$ respectively. The first to third constant current sources $I_0$ to $I_2$ are connected to a negative terminal of the direct current power supply $V_{CC}$ commonly. Outputs of first and second output terminals $T_1$ and $T_2$ provided at the collectors of the first and second transistors $Q_1$ and $Q_2$ respectively are supplied to an external circuit.

In operation, an input signal $V_S$ is applied differentially to the bases of the emitter follower transistors $Q_3$ and $Q_4$ with a bias voltage. Though the input signal is attenuated slightly at the first and second emitter follower transistors $Q_1$ and $Q_2$, however, the input signal is amplified at the first and second transistors $Q_1$ and $Q_2$ , and is supplied to the first and second output terminals $T_1$ and $T_2$ differentially. In general, the outputs of the terminals $T_1$ and $T_2$ are amplified differentially by a differential amplifying circuit of the next stage.

Next, a differential amplifying circuit in a first preferred embodiment will be explained in conjunction with Fig. 2.

The differential amplifying circuit includes first and second transistors $Q_6$ and $Q_7$ , first and second load resistances $R_3$ and $R_4$ , and a first constant current source $I_3$ . The first and second transistors $Q_6$ and $Q_7$ are connected at emitters with the first constant current source $I_3$ commonly. The first and second load resistors $R_3$ and $R_4$ are connected at first terminals to collectors of the first and second transistors $Q_6$ and $Q_7$ respectively. The first transistor $Q_6$ is connected at a base to an emitter of an emitter follower transistor $Q_5$. The emitter follower transistor $Q_5$ is connected at a collector to the positive terminal of the direct current power supply $V_{CC}$ commonly, at a base to a signal source $V_S$ in which a positive component is supplied thereto, and at an emitter to second terminals of the first and second resistances $R_3$ and $R_4$ commonly. The second transistor $Q_7$ is connected at a base to a bias power supply $V_S$ from which a predetermined level of a bias voltage is applied thereto. A negative terminal of the direct current power supply $V_{CC}$ is connected to the constant current source $I_3$.

In operation, an input signal $V_S$ is applied to the base of the emitter follower transistor $Q_5$ with a bias voltage. The input signal is amplified by the first transistor $Q_6$ and supplied to first output terminal $T_1$ provided at the collectors of the first and second transistors $Q_6$ and $Q_7$.

In this differential amplifying circuit, there occurs direct current drop in the first and second resistances $R_3$ and $R_4$ . Therefore, a value of the first resistance $R_3$ should be determined so that a voltage $V_{CE}$ between the collector and the emitter of the first transistor $Q_6$ becomes at least 0.1 V (preferably in the range of 0.2 V to 0.5 V). The voltage $V_{CE}$ is obtained by the following formula:

$$V_{CE} = V_{BE} - I_3 R_3 /2$$

where $V_{BE}$ is a voltage between the base and the emitter of the first transistor $Q_5$ . Such a condition can be realized by setting the same conditions as like in an internal gate circuit of an ECL (Emitter Coupling Logic).

In this embodiment, a sum of collector currents of the first and second transistors $Q_6$ and $Q_7$ , which is a bias current of the emitter follower transistor $Q_5$, is approximately equal to a sum of emitter currents thereof which is equal to the constant current flowing through the constant current source $I_3$, because each of base currents thereof is minimum in compared with the collector currents. Therefore, the emitter follower transistor $Q_5$ is biased by the constant current source $I_3$ , so that it is not necessary to provide an additional current source for biasing the emitter follower transistor $Q_5$.

Though there is no problem when the outputs are picked up from the first and second output terminals $T_1$ and $T_2$ differentially, the outputs become values of (gain - 1) in the first terminal $T_1$ and (gain + 1) in the second terminal $T_2$ respectively if the output is picked up from only one of either of the first and second terminals $T_1$ and $T_2$ , because an alternative signal corresponding to the input signal is supplied to both terminals.

Next, a differential amplifying circuit in the second preferred embodiment will be explained in conjunction with Fig. 3. The circuitry structure of the differential amplifying circuit is the same as that in Fig. 2, except that the circuit is further provided with a

transistor $Q_8$ and two resistances $R_5$ and $R_6$. The transistor $Q_8$ is connected at a base to ground, at a collector to a positive terminal of a direct current power supply $V_{CC}$, and at an emitter to first terminals of the resistances $R_5$ and $R_6$ commonly. The resistors $R_5$ and $R_6$ are connected at second terminals to collectors of the first and second transistors $Q_6$ and $Q_7$.

In this differential amplifying circuit, proportion of a bias currents of the emitter follower transistor $Q_5$ and that of the first and second transistors $Q_6$ and $Q_7$ are adjusted to be adequate by providing the transistor $Q_8$ and the resistances $R_5$ and $R_6$. Now, tt is supposed that the adequate level of the bias current of the emitter follower transistor $Q_5$ is 2.5 mA and a constant current of the constant current source $I_3$ is 2.5 mA. Such a condition can be realized by setting the base voltage level of the transistor $Q_8$ as the same level of the DC bias voltage level of that of the emitter follower transistor $Q_5$ and setting each of the resistances $R_3$ to $R_6$ to have the same resistance, when the differential amplifying circuit is biased. In such a case, the same amount of current, that is 1.25 mA, flows through each of the resistances $R_3$ to $R_6$, so that the current of the emitter follower transistor $Q_5$ becomes 2.5 mA, which is a sum of currents flowing the resistances $R_3$ and $R_4$. Consequently, the adequate level of current flows through the emitter follower transistor $Q_5$, so that the emitter follower transistor $Q_5$ does not consume an excess power.

Next, a differential amplifying circuit in a third preferred embodiment will be explained in conjunction with Fig. 4. In this embodiment, first and second units each composing a differential amplifying circuit are provided in parallel. The first unit includes two transistors $Q_{11}$ and $Q_{12}$, two load resistances $R_7$ and $R_8$ and a constant current source $I_4$, while the second unit includes two transistors $Q_{13}$ and $Q_{14}$, two load resistances $R_9$ and $R_{10}$ and a constant current source $I_5$. Each of the two units has the same circuitry structure which is the same as the differential amplifying circuit in Fig. 2. Emitter follower transistors $Q_9$ and $Q_{10}$ are also provided. The emitter follower transistors $Q_9$ and $Q_{10}$ are supplied at bases with an input signal differentially as like in Fig. 1, in which a positive component of the input signal to the base of the emitter follower transistor $Q_{10}$ and a negative component thereof to the base of the emitter follower transistor $Q_9$. The emitter follower transistor $Q_9$ is connected at an emitter to bases of the transistors $Q_{11}$ and $_{13}$ and the resistances $R_7$ and $R_8$. On the other hand, the emitter follower transistor $Q_{10}$ is connected at an emitter to bases of the transistors $Q_{12}$ and $Q_{14}$ and the resistances $R_9$ and $R_{10}$. A direct current power supply $V_{CC}$ is connected at a positive terminal to collectors of the emitter follower transistors $Q_9$ and $Q_{10}$, and at a negative terminal to the constant current sources $I_4$ and $I_5$. Output terminals $T_3$ to $T_6$ are provided at collectors of the transistors $Q_{11}$ to $Q_{14}$, respectively, from which outputs of the differential amplifying circuit are picked up.

In this embodiment, there are several ways for picking up outputs of the differential amplifying circuit. In the first way, a differential voltage level between the output terminals $T_3$ and $T_4$ and a differential voltage level between the output terminals $T_5$ and $T_6$ are picked up, respectively, and then the two differential voltage levels are summed to be an output of the circuit. In practical, the differential outputs of the output terminals $T_3$ and $T_4$ are supplied to inputs of a first differential amplifying circuit of the next stage, while the differential outputs of the output terminals $T_5$ and $T_6$ are supplied to inputs of a second differential amplifying circuit of the next stage. Then outputs of the first and second differential amplifying circuit of the next stage are summed. In the second way, an output picked up from the output terminals $T_3$ and $T_5$ which are connected each other and an output picked up from the output terminals $T_4$ and $T_6$ which are connected each other are differentially picked up.

In the third way, only one differential output of either the output terminals $T_3$ and $T_4$ or the output terminals $T_5$ and $T_6$ is picked up. In the fourth way, only one differential output of either the output terminals $T_4$ and $T_5$ or the output terminals $T_3$ and $T_6$ is picked up. In the fifth way, only one output of either of the four terminals $T_3$ to $T_6$ are picked up.

In any case, the circuit may have the same power consumption and frequency and noise characteristics as those in Fig. 2 on conditions that constant currents of the constant current source $I_4$ and $I_5$ are both equal to half of the constant current of the constant current source $I_5$ in Fig. 2, resistances of all of the load resistances $R_7$ to $R_{10}$ are equal to a doubled value of the load resistance $R_3$ in Fig. 2, and each size of all of the transistors $Q_{11}$ to $Q_{14}$ is equal to half of that of the transistor $Q_6$ in Fig. 2.

Next, a differential amplifying circuit in a fourth preferred embodiment will be explained in conjunction with Fig. 5. The circuitry structure of the differential amplifying circuit is the same as that in Fig. 4, except that the circuit is further provided with two transistors $Q_{15}$ and $Q_{16}$ and four resistances $R_{11}$ to $R_{14}$. The transistor $Q_{15}$ is connected at a base to ground, at a collector to a positive terminal of a direct current power supply $V_{CC}$, and at an emitter to first terminals of the resistances $R_{11}$ and $R_{12}$ commonly. The resistances $R_{11}$ and $R_{12}$ are connected at second terminals to the collectors of the transistors $Q_{11}$ and $Q_{12}$. On the other hand, the transistor $Q_{16}$ is connected at a base to ground, at a collector to the positive terminal of the direct current power supply $V_{CC}$, and at an emitter to first terminals of the resistances $R_{13}$ and $R_{14}$ commonly. The resistances $R_{13}$ and $R_{14}$ are connected at second terminals to the collectors of the transistors $Q_{13}$ and $Q_{14}$.

In this differential amplifying circuit, proportion of bias currents of the emitter follower transistors $Q_9$ and $Q_{10}$ and those of the transistors $Q_{11}$ to $Q_{14}$ are adjusted by providing the transistors $Q_{15}$ and $Q_{16}$ and the resistances $R_{11}$ to $R_{14}$ as like the transistor $Q_8$ and resistance $R_5$ and $R_6$ in Fig. 3.

Next, a differential amplifying circuit in a fifth embodiment will be explained in conjunction with Fig. 6. In this embodiment, the circuitry structure is the same as that in Fig. 4, except that the transistors $Q_{11}$ and $Q_{13}$ and the transistors $Q_{12}$ and $Q_{14}$ are short-circuited respectively and the two constant current sources $I_4$ and $I_5$ are replaced by a constant current source $I_6$. In Fig. 4, the common signals are supplied to the transistors $Q_{11}$ and $Q_{13}$ and the transistors $Q_{12}$ and $Q_{14}$, respectively, so that the same signals are generated at the emitters of the the transistors $Q_{11}$ and $Q_{13}$ and at the emitters of the transistors $Q_{12}$ and $Q_{14}$. Therefore, the differential amplifying circuit has the same equivalent circuit structure as that in Fig. 4, so that operation thereof is the same as that in Fig. 4.

Next, a differential amplifying circuit in a sixth embodiment will be explained in conjunction with Fig. 7. In this embodiment, the circuitry structure is the same as that in Fig. 6, except that the differential amplifying circuit is further provided with a transistor $Q_{15}$ and four load resistances $R_{15}$ to $R_{18}$. The transistor $Q_{15}$ is connected at a base to ground, at a collector to a positive terminal of a direct current power supply $V_{CC}$, and at an emitter to first terminals of the resistances $R_{15}$ to $R_{18}$ commonly. The resistances $R_{15}$ to $R_{18}$ are connected at second terminals to the collectors of the transistors $Q_{11}$ to $Q_{14}$. The transistor $Q_{15}$ functions at a by-pass as like the transistor $Q_8$ in Fig. 3 or the transistors $Q_{15}$ and $Q_{16}$ in Fig. 5. The operation thereof is the same as that in Fig. 6.

Although the invention has been described with respect to specific embodiment for complete and clear disclosure, the appended claims are not to thus limited and alternative constructions that may occur to one skilled in the art which fairly fall within the basic teaching herein set forth.

## Claims

1. A differential amplifying circuit, comprising:
first ($Q_6$) and second ($Q_7$) transistors for differentially amplifying an input signal;
first ($R_3$) and second ($R_4$) load elements;
a constant current source ($I_3$); and
an emitter follower transistor ($Q_5$); wherein:
said first and second transistors are connected at emitters to said constant current source commonly, and at collectors to first terminals of said first and second load elements, respectively;
said first transistor is connected at a base to an emitter of said emitter follower transistor;
said first and second load elements are connected at second terminals to an emitter of said emitter follower transistor commonly; and
said emitter follower transistor is connected with a signal source ($V_s$) for supplying said input signal thereto with a bias voltage.

2. A differential amplifying circuit, according to claim 1, further comprising:
a third transistor ($Q_8$) connected at a base to ground and at a collector with a collector of said emitter follower transistor; and
third ($R_5$) and fourth ($R_6$) load elements connected at first terminals to an emitter of said third transistor commonly and second terminals to collectors of said first and second transistors.

## Patentansprüche

1. Differenzverstärkerschaltung, die aufweist:
einen ersten ($Q_6$) und einen zweiten ($Q_7$) Transistor zur differentialen Verstärkung eines Eingangssignals;
ein erstes ($R_3$) und ein zweites ($R_4$) Lastelement;
eine Konstantstromquelle ($I_3$); und
einen Emitterfolgertransistor ($Q_5$); wobei:
der erste und der zweite Transistor mit den Emittern gemeinsam an die Konstantstromquelle angeschlossen sind und mit den Kollektoren an erste Anschlüsse des ersten bezw. des zweiten Lastelements angeschlossen sind;
der erste Transistor mit einer Basis an einen Emitter des Emitterfolgertransistors angeschlossen ist;
das erste und das zweite Lastelement mit zweiten Anschlüssen gemeinsam an einen Emitter des Emitterfolgertransistors angeschlossen sind; und
der Emitterfolgertransistor an eine Signalquelle ($V_s$) zur Einspeisung des Eingangssignals in denselben mit einer Vorspannung angeschlossen ist.

2. Differenzverstärkerschaltung nach Anspruch 1, die weiter aufweist:
einen dritten Transistor ($Q_8$), der mit einer Basis an Masse und mit einem Kollektor an den Kollektor des Emitterfolgertransistors angeschlossen ist; und
ein drittes ($R_5$) und viertes ($R_5$) Lastelement, die mit ersten Anschlüssen gemeinsam an einen Emitter des dritten Transistors und mit zweiten Anschlüssen an Kollektoren des ersten und des zweiten Transistors angeschlossen sind.

## Revendications

1. Circuit amplificateur différentiel comprenant:

des premier ($Q_6$) et deuxième ($Q_7$) transistors pour l'amplification différentielle d'un signal d'entrée;

des premier ($R_3$) et deuxième ($R_4$) éléments de charge;

une source ($I_3$) de courant constant; et

un transistor ($Q_5$) émetteur-suiveur; dans lequel

lesdits premier et deuxième transistors sont reliés par leurs émetteurs à la même borne de la source de courant constant et par leurs collecteurs, aux premières bornes desdits premier et deuxième éléments de charge, respectivement;

ledit premier transistor est relié par sa base, à un émetteur dudit transistor émetteur-suiveur;

lesdits premier et deuxième éléments de charge sont reliés par leur deuxième borne commune à un émetteur dudit transistor émetteur-suiveur; et

ledit transistor émetteur-suiveur est relié à une source ($V_s$) de signaux destinée à lui fournir ledit signal d'entrée avec une tension de polarisation.

**2.** Circuit amplificateur différentiel selon la revendication 1, comprenant en outre

un troisième transistor ($Q_8$) relié par sa base à la masse et par son collecteur au collecteur dudit transistor émetteur-suiveur; et

des troisième ($R_5$) et quatrième ($R_5$) éléments de charge reliés par leur première borne commune à un émetteur dudit troisième transistor et par leurs deuxièmes bornes aux collecteurs desdits premier et deuxième transistors.

FIG. 1 PRIOR ART

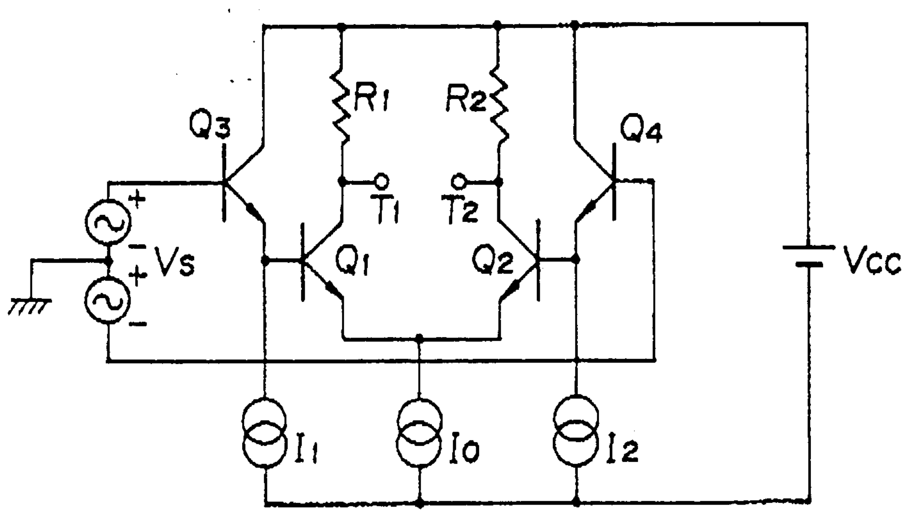

FIG. 2

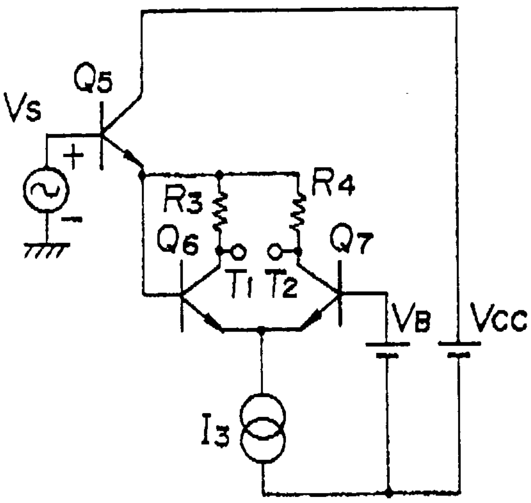
Q5
Vs
+
-
R3
R4
Q6
T1
T2
Q7
VB
Vcc
I3

FIG. 3

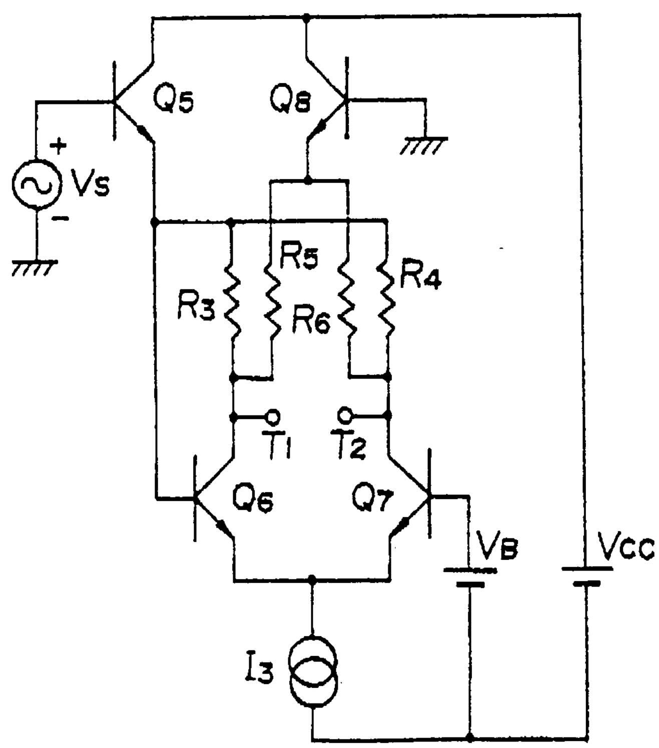
Q5
Q8
+
Vs
-
R5
R4
R3
R6
T1
T2
Q6
Q7
VB
Vcc
I3

FIG. 4

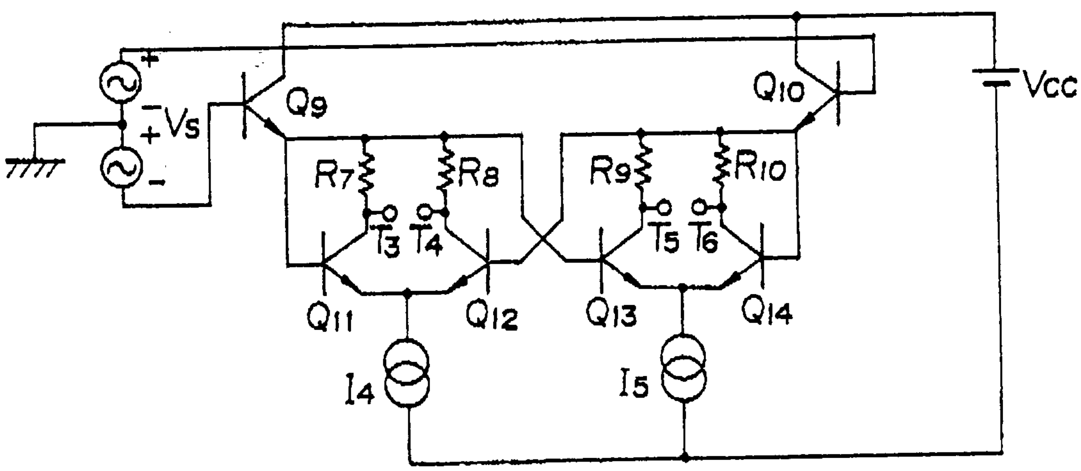

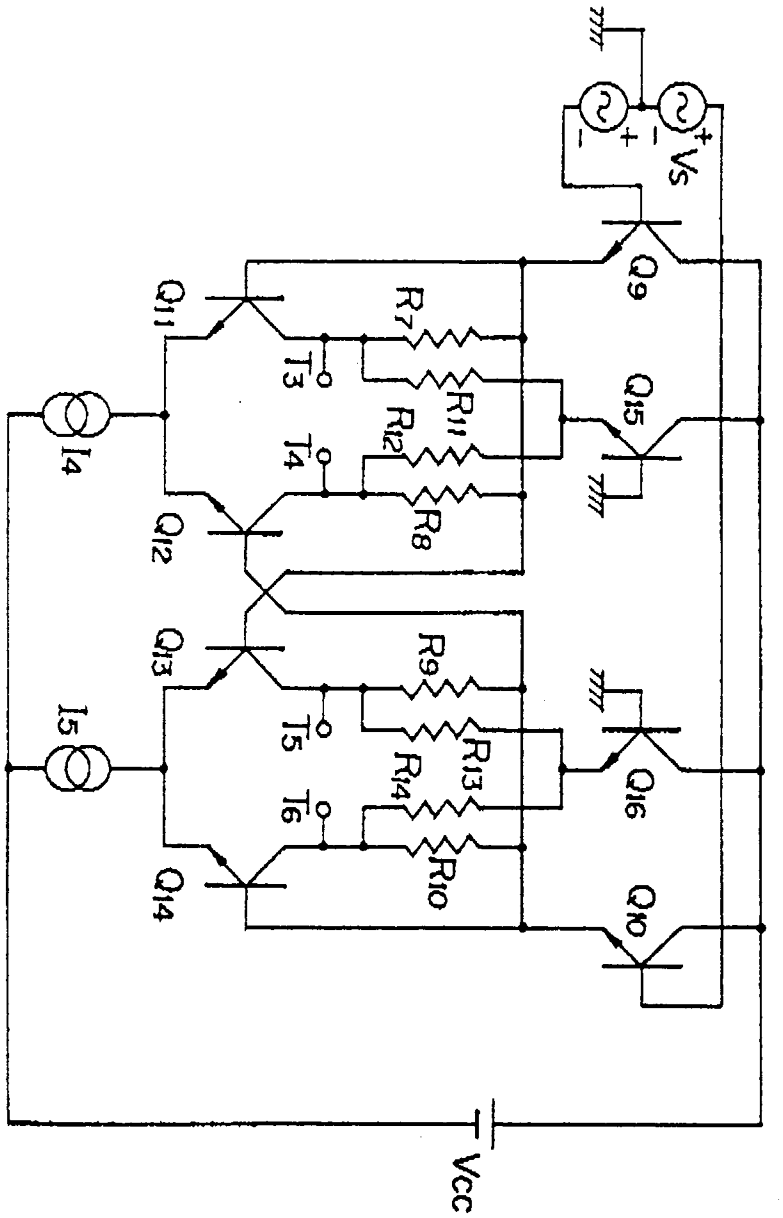
Vs
Q9
Q15
Q16
Q10
Q11
Q12
Q13
Q14
R7
R8
R9
R10
R11
R12
R13
R14
T3
T4
T5
T6
I4
I5
Vcc

FIG. 5

FIG. 6

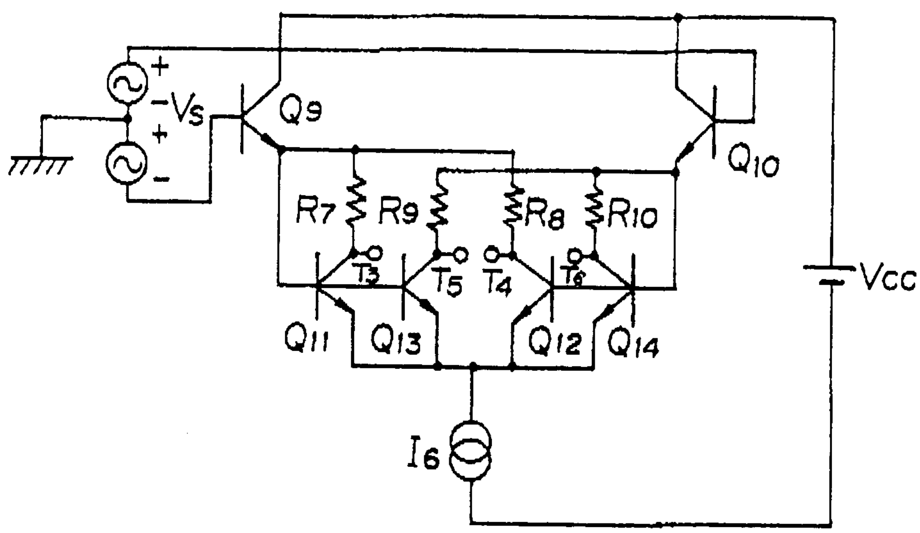
+
-
Vs
+
-
Q9
Q10
R7
R9
R8
R10
T3
T5
T4
T6
Vcc
Q11
Q13
Q12
Q14
I6

FIG. 7

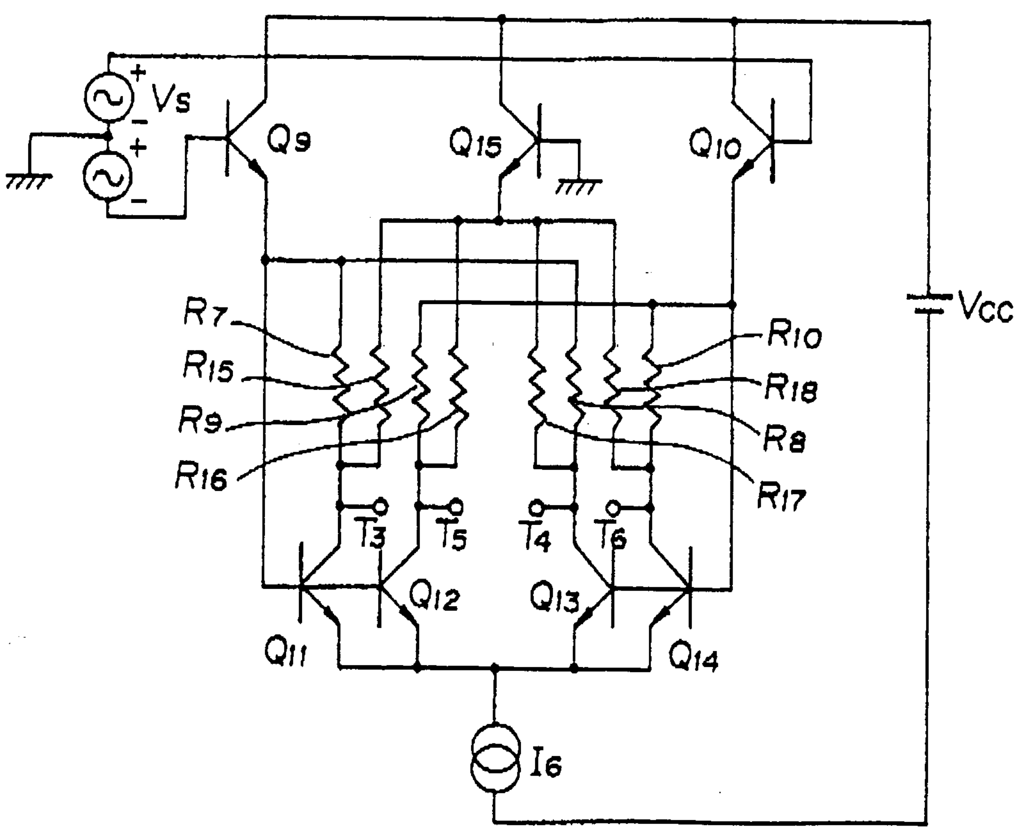
+
Vs
-
+
-
Q9
Q15
Q10
R7
R15
R9
R16
R10
R18
R8
R17
Vcc
T3
T5
T4
T6
Q12
Q13
Q11
Q14
I6